# FASCICULE DE BREVET EUROPEEN

(11) **EP 0 667 675 B1**
(45) Date de publication et mention de la délivrance du brevet: **30.09.1998**
(21) Numéro de dépôt: 95400260.6
(22) Date de dépôt: 08.02.1995
(51) Int. Cl.: H03G 1/04, H03G 3/20, H03F 1/02

(54) **Dispositif de commande de la polarisation d'un amplificateur**
Verfahren zur Steuerung der Vorspannung eines Verstärkers
Bias control device for an amplifier

(30) Priorité: 11.02.1994 FR 9401581
(43) Date de publication de la demande: 16.08.1995
(73) Titulaire: ALCATEL ALSTHOM COMPAGNIE GENERALE D'ELECTRICITE, 75008 Paris (FR); ALCATEL MOBILE COMMUNICATION FRANCE, 75008 Paris (FR)
(72) Inventeur: Gourgue, Frédéric, F-75017 Paris (FR); Soula, Véronique, F-75017 Paris (FR)
(74) Mandataire: Pothet, Jean Rémy Emile Ludovic

(56) Documents cités:
- EP-A- 0 289 807
- EP-A- 0 566 406
- FR-A- 2 080 248

## Description

Le domaine de l'invention est celui des amplificateurs, et notamment des amplificateurs de puissance utilisés en hyperfréquence, dont la puissance de sortie est variable et dont la bande de fréquences d'émission est prédéterminée (on parle également de canal alloué).

Le document EP-A-0 566 406 mentionne un amplificateur dont le niveau de puissance est régulé.

De tels amplificateurs sont par exemple utilisés dans les systèmes de radiocommunication cellulaires, et notamment dans les systèmes GSM (Groupe Spécial Mobile) et TETRA (Trans-European Trunked Radio), où chaque station mobile se voit attribuer un canal de transmission (c'est-à-dire une bande de fréquences).

Ainsi, par exemple, dans chaque station mobile du système GSM, un amplificateur doit émettre un signal amplifié dans le canal qui lui est alloué, la puissance de sortie variant par pas de 2 dB sur une plage d'au moins 24 dB, de façon à permettre un fonctionnement optimal du système.

Un autre exemple est le système TETRA, dans lequel un amplificateur doit également émettre un signal amplifié dans le canal qui lui est alloué, mais où la puissance de sortie varie par pas de 5 dB entre la puissance maximale prévue (pour la station mobile) et 15 dBm.

Il est connu que les amplificateurs utilisés en hyperfréquences ont des fonctions de transfert présentant des non-linéarités d'autant plus fortes que le niveau de puissance de sortie est élevé. Ces non-linéarités se traduisent par l'apparition de produits d'intermodulation qui élargissent le spectre des signaux amplifiés.

Or, cet élargissement spectral est préjudiciable au bon fonctionnement du système radio dans lequel sont mis en oeuvre les amplificateurs. En effet, cela signifie que le signal amplifié déborde du canal qui lui est alloué (émission hors-bande) et représente un signal parasite pour les canaux adjacents.

Ainsi, dans les applications radiomobiles, le niveau maximal d'émission hors-bande (c'est-à-dire le niveau maximal d'émission parasite) est spécifié et imposé de manière à limiter les interférences entre canaux et garantir le bon fonctionnement du système radiomobile.

On connaît plusieurs solutions permettant de limiter les émissions hors-bande d'un amplificateur.

Une première solution connue consiste à utiliser l'amplificateur très en deçà de sa capacité, de façon à travailler en permanence dans une zone linéaire (la non-linéarité se manifestant d'autant moins que le niveau de puissance est faible). Cela revient par exemple, pour un amplificateur susceptible de délivrer une puissance maximale de 100 W, à le polariser pour cette puissance maximale mais à ne l'utiliser que pour une puissance de 10 W. En d'autres termes, on polarise l'amplificateur de façon que les contraintes de linéarité soient respectées pour la puissance d'émission maximale, et on conserve cette polarisation quelle que soit la puissance réelle d'émission.

Cette première solution connue présente un inconvénient majeur, à savoir son très faible rendement en puissance (c'est-à-dire le rapport entre la puissance du signal HF en sortie et la puissance fournie par l'alimentation).

En effet, le fait de faire travailler l'amplificateur en deçà de sa capacité implique une consommation élevée et une quantité importante d'énergie à dissiper, et donc l'utilisation de radiateurs de tailles et de poids importants pour dissiper cette énergie. Or, dans les systèmes de radiocommunication, à chaque station mobile est associé un dispositif portatif alimenté par batterie et comprenant un amplificateur. Par conséquent, une consommation élevée des amplificateurs se traduit par une limitation de l'autonomie des dispositifs portatifs, et l'utilisation de radiateurs de tailles et poids importants augmente l'encombrement et le poids des dispositifs portatifs.

Une seconde solution connue permettant de limiter les émissions hors bande d'un amplificateur consiste à adjoindre à l'amplificateur un dispositif de linéarisation permettant de limiter l'élargissement spectral. Cette seconde solution permet d'améliorer le rendement en puissance sans toutefois l'optimiser.

En définitive, il est clair qu'il est préférable d'avoir un bon rendement en puissance et une bonne linéarité. Mais ces deux grandeurs étant contradictoires, l'obtention d'une linéarité respectant les contraintes sur les émissions hors bande se fait toujours au détriment du rendement de puissance.

L'invention a notamment pour objectif de pallier ces différents inconvénients de l'état de la technique.

Plus précisément, l'objectif principal de la présente invention est de fournir un dispositif de commande de la polarisation d'un amplificateur, ce dispositif permettant, par ajustement de la polarisation, d'obtenir le meilleur couple (rendement, linéarité) quel que soit le niveau de puissance de sortie de l'amplificateur.

Par conséquent, l'invention a notamment pour objectif d'améliorer l'autonomie des dispositifs portatifs comprenant un tel amplificateur, et réduire soit l'encombrement et le poids de ces dispositifs portatifs en permettant une réduction de la taille des radiateurs réalisant la dissipation d'énergie, soit la taille des batteries utilisées.

Cet objectif principal, ainsi que d'autres qui apparaîtront par la suite, sont atteints selon l'invention à l'aide d'un dispositif de commande de la polarisation d'un amplificateur du type recevant un signal d'entrée à amplifier et un signal de polarisation, et délivrant un signal de sortie amplifié, ledit amplificateur possédant au moins deux valeurs distinctes de puissance de sortie possibles et émettant ledit signal de sortie amplifié principalement dans une bande de fréquences prédéterminée,
ledit dispositif comprenant des moyens de commande de la polarisation dudit amplificateur qui reçoivent une information de contrôle de linéarité, et génèrent ledit signal de polarisation en fonction de ladite information de contrôle de linéarité et de façon qu'un niveau réel d'émission hors bande soit sensiblement égal à un niveau désiré d'émission hors-bande,
ledit niveau réel d'émission hors bande étant défini comme un niveau d'émission dudit signal de sortie amplifié hors de ladite bande de fréquences prédéterminées, et ledit niveau désiré d'émission hors bande étant défini comme un niveau seuil maximal prédéterminé d'émission hors bande, pour n'importe laquelle desdites valeurs distinctes de puissance de sortie possibles.

Ainsi, le principe de l'invention est de maintenir un bon couple (rendement, linéarité) quel que soit le niveau de puissance en sortie, puisque le rendement est optimisé et la linéarité est toujours suffisante.

En d'autres termes, l'invention permet de modifier la polarisation de l'amplificateur de façon que, quelle que soit la puissance de sortie, le niveau d'émission hors bande soit maximal tout en respectant les contraintes prédéterminées d'émission hors bande.

Par ajustement de la polarisation de l'amplificateur, on entend l'ajustement de la polarisation des transistors de cet amplificateur, c'est-à-dire le réglage du point de repos et des tensions d'alimentation de ces transistors.

Dans un premier mode de réalisation préférentiel de l'invention, ladite information de contrôle de linéarité est une valeur de puissance de sortie requise parmi lesdites au moins deux valeurs distinctes de puissance de sortie possibles, lesdits moyens de commande associant un signal de polarisation distinct à chacune desdites au moins deux valeurs distinctes de puissance de sortie possibles, chaque signal de polarisation distinct étant prédéterminé de façon que, pour la valeur de puissance de sortie à laquelle il est associé, le niveau réel d'émission hors bande soit sensiblement égal au niveau désiré d'émission hors bande.

Ainsi, le dispositif de l'invention permet d'ajuster de manière prédéterminée (en boucle ouverte) le point de fonctionnement de l'amplificateur en fonction de la valeur de puissance de sortie requise. Cette valeur de puissance de sortie requise peut être fournie par un organe extérieur au dispositif (par exemple un micro-contrôleur supervisant le fonctionnement de l'ensemble). L'ajustement de manière prédéterminée du point de fonctionnement consiste à choisir, parmi une pluralité de signaux de polarisation distincts prédéterminés, celui qui est associé à la valeur de puissance de sortie requise. L'association d'un signal de polarisation distinct à chacune des valeurs de puissance de sortie requise se fait à la conception, et de façon à garantir un niveau réel d'émission hors bande sensiblement égal ou en deçà du seuil prescrit (tout en tenant éventuellement compte d'éventuelles dérives dues par exemple au vieillissement, à une fluctuation de la tension d'alimentation, à la température, etc...).

Avantageusement, ledit dispositif comprend des moyens de mesure d'au moins un paramètre extérieur, et lesdits moyens de commande reçoivent également ledit au moins un paramètre extérieur et génèrent ledit signal de polarisation en fonction également dudit au moins un paramètre extérieur. Préférentiellement, ledit au moins un paramètre extérieur appartient au groupe comprenant :
- une tension d'alimentation dudit amplificateur ; et
- une température dudit amplificateur.

Dans un second mode de réalisation préférentiel de l'invention, ledit dispositif comprend :
- des moyens de prélèvement dudit signal de sortie amplifié, fournissant un signal prélevé ;
- des moyens d'analyse recevant ledit signal prélevé et délivrant un niveau réel d'émission hors-bande déterminé à partir dudit signal prélevé ;
- des moyens de comparaison dudit niveau réel d'émission hors bande avec ledit niveau désiré d'émission hors-bande, lesdits moyens de comparaison délivrant un résultat qui est ladite information de contrôle de linéarité.

Ainsi, le dispositif de l'invention permet d'ajuster de manière adaptative (en boucle fermée) le point de fonctionnement de l'amplificateur en fonction du niveau réel d'émission hors bande, c'est-à-dire en fonction de la linéarité de l'amplificateur. Le niveau réel d'émission hors bande est déterminé par analyse du signal de sortie amplifié. L'ajustement de manière adaptative du point de fonctionnement consiste à comparer le niveau réel d'émission hors bande avec un niveau désiré d'émission hors bande et à jouer sur la polarisation de l'amplificateur en fonction du résultat de cette comparaison. Ainsi, si le niveau réel d'émission hors bande est supérieur au niveau désiré d'émission hors bande, on augmente la polarisation (et donc la puissance de sortie maximale) afin de faire baisser le niveau réel d'émission hors bande (en d'autres termes, on améliore alors la linéarité au détriment du rendement). Dans le cas contraire, on réduit la polarisation (et donc la puissance de sortie maximale) afin de diminuer la puissance dissipée (en d'autres termes, on améliore alors le rendement en dégradant la linéarité puisqu'on augmente le niveau réel d'émission hors bande).

Avantageusement, ledit dispositif comprend des moyens de conversion dudit signal prélevé, délivrant un signal converti auxdits moyens d'analyse, et lesdits moyens de conversion appartiennent au groupe comprenant les moyens de conversion en bande de base et les moyens de conversion en fréquence intermédiaire.

Deux cas peuvent se présenter selon que l'amplificateur reçoit uniquement un signal utile à amplifier, ou bien reçoit alternativement un signal utile à amplifier et un signal de test.

Avantageusement, lorsque ledit amplificateur est du type recevant uniquement un signal utile à amplifier, ledit dispositif est mis en oeuvre lorsque ledit amplificateur reçoit ledit signal utile à amplifier.

Préférentiellement, dans ce premier cas, lesdits moyens d'analyse comprennent :
- des moyens d'échantillonnage dudit signal prélevé, délivrant un signal échantillonné;
- des moyens de conversion analogique/numérique recevant ledit signal échantillonné et délivrant un signal numérique ; et
- des moyens de traitement numérique recevant ledit signal numérique et délivrant ledit niveau réel d'émission hors bande,
lesdits moyens de traitement numérique :
- mettent en oeuvre une analyse spectrale de façon à déterminer un spectre de puissance dudit signal numérique, associant une puissance à chacune des fréquences dudit spectre, et
- génèrent ledit niveau réel d'émission hors bande sous la forme d'un cumul de puissances associées à une partie prédéterminée des fréquences situées hors de ladite bande de fréquences prédéterminée,
et ledit niveau désiré d'émission hors bande est défini comme un niveau maximal prédéterminé de puissance cumulée.

Ainsi, lorsque l'amplificateur reçoit uniquement un signal utile à amplifier, l'estimation du niveau réel des émissions parasites se fait directement par analyse spectrale du signal en sortie de l'amplificateur.

De façon avantageuse, lorsque l'amplificateur reçoit soit un signal utile à amplifier, soit un signal de test, ledit dispositif comprend des moyens de génération d'au moins un des signaux appartenant au groupe comprenant :
- un signal de test ; et
- un signal utile à amplifier ;
et il est mis en oeuvre uniquement lorsque ledit amplificateur reçoit ledit signal de test.

Préférentiellement, ledit signal de test est constitué d'au moins deux signaux sinusoïdaux à amplifier, ledit signal de sortie amplifié étant constitué notamment d'au moins deux premiers signaux sinusoïdaux de même fréquence que lesdits au moins deux signaux sinusoïdaux à amplifier, et de seconds signaux sinusoïdaux de fréquences distinctes de celles desdits au moins deux signaux sinusoïdaux à amplifier, lesdits seconds signaux sinusoïdaux étant des produits d'intermodulation,
et ledit niveau réel d'émission hors bande déterminé par lesdits moyens d'analyse est un niveau de puissance desdits seconds signaux sinusoïdaux.

Ainsi, l'estimation du niveau réel des émission parasites se fait indirectement par l'envoi d'un signal de test puis la détermination du niveau des produits d' intermodulation.

Avantageusement, ledit signal de test est constitué de deux signaux sinusoïdaux à amplifier d'amplitudes sensiblement égales et de fréquences proches et situées dans ladite bande de fréquences prédéterminée,
et lesdits seconds signaux sinusoïdaux sont des produits d'intermodulation d'ordre impair au moins égal à trois.

De façon préférentielle, lesdits moyens d'analyse sont constitués de filtres analogiques étroits centrés sur les fréquences desdits seconds signaux sinusoïdaux, et génèrent ledit niveau réel d'émission hors bande sous la forme d'un jeu de coefficients réels, chacun desdits coefficients réels correspondant à une puissance de sortie d'un desdits filtres analogiques,
et ledit niveau désiré d'émission hors bande est défini comme un jeu de coefficients maximaux prédéterminés.

Selon une variante, lesdits moyens d'analyse comprennent :
- des moyens d'échantillonnage dudit signal prélevé, délivrant un signal échantillonné;
- des moyens de conversion analogique/numérique recevant ledit signal échantillonné et délivrant un signal numérique ; et
- des moyens de traitement numérique recevant ledit signal numérique et délivrant ledit niveau réel d'émission hors bande,
lesdits moyens de traitement numérique :
- mettent en oeuvre une analyse spectrale de façon à déterminer un spectre de puissance dudit signal numérique associant une puissance à chacune des fréquences dudit spectre, et
- génèrent ledit niveau réel d'émission hors bande sous la forme d'un jeu de coefficients réels, chacun desdits coefficients réels correspondant à une puissance d'un desdits seconds signaux sinusoïdaux,
et ledit niveau désiré d'émission hors bande est défini comme un jeu de coefficients maximaux prédéterminés.

Dans un mode de réalisation préférentiel de l'invention, ledit dispositif comprend des moyens de mesure d'au moins un paramètre extérieur, et lesdits moyens de commande reçoivent également ledit au moins un paramètre extérieur et génèrent ledit signal de polarisation en fonction également dudit au moins un paramètre extérieur.

Avantageusement, ledit au moins un paramètre extérieur appartient au groupe comprenant :
- une tension d'alimentation dudit amplificateur;
- une température dudit amplificateur ; et
- une valeur de puissance de sortie requise parmi lesdites au moins deux valeurs distinctes de puissance de sortie possibles.

Dans un mode de réalisation avantageux de l'invention, ledit amplificateur étant du type associé à un dispositif de linéarisation comportant une boucle de contre-réaction, ledit dispositif de commande de la polarisation utilise au moins partiellement ladite boucle de contre-réaction. Ainsi, le coût du dispositif de l'invention peut être réduit.

Avantageusement, ladite boucle contre-réaction comprend au moins certains des moyens appartenant au groupe comprenant :
- lesdits moyens de prélèvement du signal de sortie amplifié ;
- lesdits moyens de conversion dudit signal prélevé ;
- lesdits moyens d'échantillonnage du signal prélevé ; et
- lesdits moyens de conversion analogique/numérique du signal échantillonné.

D'autres caractéristiques et avantages de l'invention apparaîtront à la lecture de la description suivante de plusieurs modes de réalisation préférentiels de l'invention, donnés à titre d'exemple indicatif et non limitatif, et des dessins annexés dans lesquels :
- la figure 1 présente un schéma de principe d'un ensemble constitué d'un amplificateur et d'un dispositif selon l'invention ;
- chacune des figures 2, 3 et 4 présente un schéma simplifié d'un mode de réalisation distinct d'un dispositif selon l'invention ; et
- la figure 5 présente un schéma simplifié d'un mode de réalisation préférentiel des moyens d'analyse apparaissant sur les figures 3 et 4.

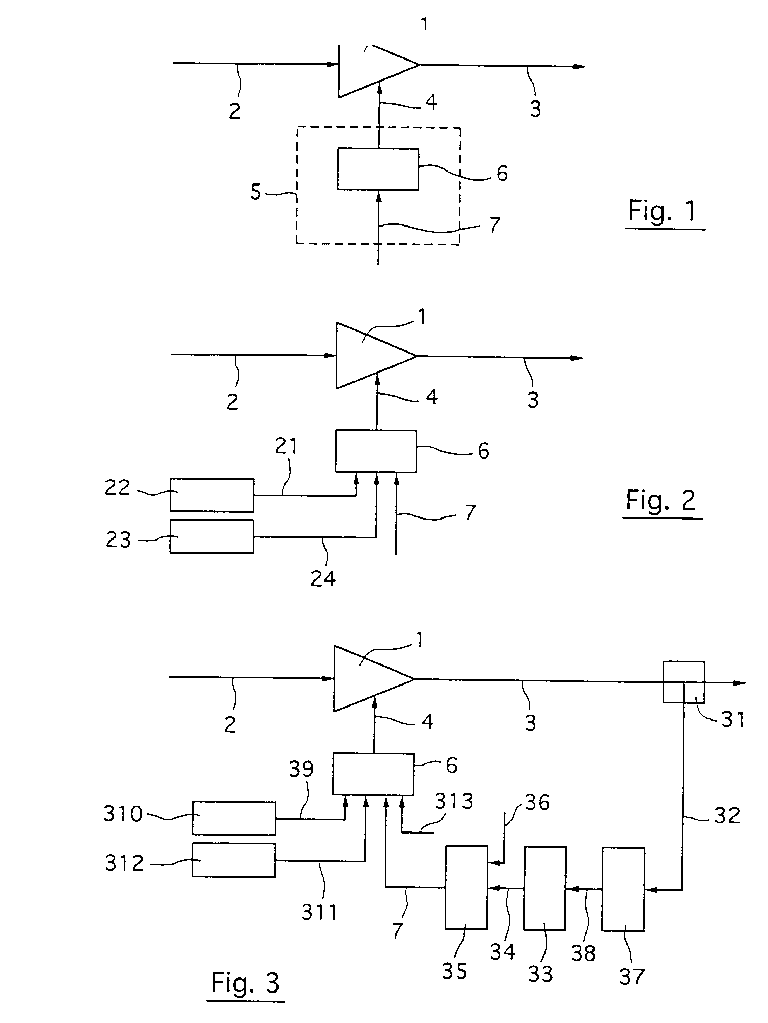

L'invention concerne donc un dispositif de commande de la polarisation d'un amplificateur. La figure 1 présente un schéma de principe d'un tel ensemble. L'amplificateur 1 reçoit un signal d'entrée à amplifier 2 et délivre un signal de sortie amplifié 3. L'amplificateur 1 reçoit également un signal de polarisation 4 permettant d'influer sur son point de fonctionnement. En effet, le signal de polarisation 4 permet d'ajuster la polarisation des transistors de l'amplificateur 1, et notamment le point de repos et les tensions d'alimentation de ces transistors.

L'amplificateur 1 est du type présentant une puissance de sortie variable et émettant dans une bande de fréquences prédéterminée. Il s'agit par exemple d'un amplificateur du type utilisé dans chacune des stations mobiles d'un système de radiocommunication cellulaire GSM ou TETRA. En effet, un tel amplificateur doit émettre dans un canal alloué et présente une puissance de sortie pouvant varier :
- par pas de 2 dB sur une plage d'au moins 24dB, dans le cas GSM ;
- par pas de 5 dB entre la puissance maximale prévue et 15 dBm, dans le cas TETRA.

Le dispositif de l'invention 5 fournit le signal de polarisation 4 de l'amplificateur 1. Plus précisément, le dispositif de l'invention 5 comprend des moyens 6 de commande de la polarisation de l'amplificateur 1 qui génèrent le signal de polarisation 4 en fonction d'une information de contrôle de linéarité 7 qu'ils reçoivent.

Le signal de polarisation 4, qui est fonction de l'information de contrôle de linéarité 7, agit sur l'amplificateur 1 de façon à modifier le niveau réel d'émission hors bande et à le rendre sensiblement égal au niveau désiré d'émission hors bande.

Un niveau (réel ou désiré) d'émission hors bande est par exemple défini comme un niveau d'émission parasites dans les canaux adjacents au canal alloué (c'est-à-dire un niveau d'émissions hors de la bande de fréquences prédéterminée dans laquelle l'amplificateur 1 doit normalement émettre).

Le niveau réel d'émission hors bande est le niveau d'émission hors bande qui existe réellement en sortie de l'amplificateur. Le niveau désiré d'émission hors bande est le niveau que l'on souhaite voir prendre par le niveau réel d'émission hors bande. ce niveau désiré d'émission hors bande est un niveau seuil maximal prédéterminé, qui est généralement suffisamment faible pour limiter substantiellement les interférences entre canaux adjacents.

La figure 2 présente un premier mode de réalisation du dispositif selon l'invention de commande de la polarisation d'un amplificateur.

Dans ce premier mode de réalisation, l'information de contrôle de linéarité 7 reçue par les moyens 6 de commande est une valeur de puissance de sortie requise. Cette valeur de puissance de sortie requise 7, qui est par exemple fournie par un micro-contrôleur (non représenté) supervisant le fonctionnement de l'ensemble constitué de l'amplificateur et du dispositif de l'invention, est l'une des valeurs de puissance de sortie possibles (réparties sur une plage de 24 dB et espacées de 2 dB les unes par rapport aux autres, dans le cas du système GSM ; réparties entre la puissance maximale prévue et 15 dBm, et espacées de 5 dB les unes par rapport aux autres, dans le cas du système TETRA).

Les moyens 6 de commande délivrent un signal de polarisation 4 fonction de la valeur de puissance de sortie requise 7. Pour ce faire, les moyens 6 de commande associent un signal de polarisation 4 distinct à chaque valeur de sortie possible. Les différents signaux de polarisation sont prédéterminés lors de la conception de façon que, pour une valeur de puissance de sortie requise, le signal de polarisation associé joue sur l'amplificateur afin de modifier le niveau réel d'émission hors bande et rendre ce niveau réel d'émission hors bande sensiblement égal au niveau désiré d'émission hors bande.

Lors de la prédétermination des différents signaux de polarisation, il est possible de tenir compte d'éventuelles dérives dues par exemple au vieillissement, à une fluctuation de la tension d'alimentation, ou encore à une fluctuation de la température.

Le dispositif de commande peut également comprendre des moyens de mesure d'un ou plusieurs paramètres extérieurs devant être pris en compte par les moyens 6 de commande, en plus de l'information de contrôle de linéarité, pour prédéterminer les différents signaux de polarisation. Ainsi, sur la figure 2, le dispositif de commande comprend des moyens 22 de mesure de la tension d'alimentation 21 de l'amplificateur 1, et des moyens 23 de mesure de la température 24 de l'amplificateur 1.

Le premier mode de réalisation du dispositif de l'invention, décrit en relation avec la figure 2, permet donc de contrôler le point de fonctionnement de l'amplificateur 1 de manière prédéterminée en fonction de la puissance de sortie requise et éventuellement de la tension d'alimentation et de la température.

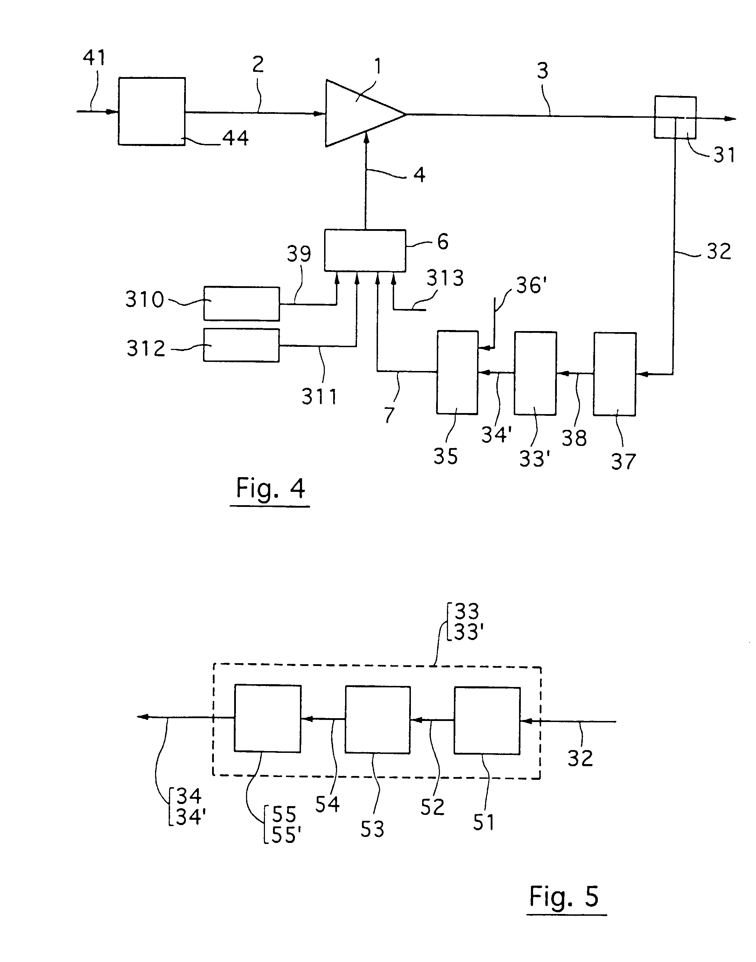

Dans les second et troisième modes de réalisation du dispositif de l'invention, présentés ci-dessous en relation avec les figures 3 et 4 respectivement, le point de fonctionnement de l'amplificateur 1 est ajusté de manière adaptative, en boucle fermée, après évaluation de la linéarité de l'amplificateur par analyse du signal de sortie amplifié. Dans ces second et troisième modes de réalisation, l'information de contrôle de linéarité 7 reçue par les moyens 6 de commande est le résultat d'une comparaison entre le niveau réel d'émission hors bande et le niveau désiré d'émission hors bande.

Dans ces second et troisième modes de réalisation, le dispositif de l'invention comprend :
- des moyens 31 de prélèvement du signal de sortie amplifié 3, fournissant un signal prélevé 32 ;
- des moyens 33, 33' d'analyse recevant le signal prélevé 32 et délivrant un niveau réel d'émission hors bande 34, 34' ;
- des moyens 35 de comparaison du niveau réel d'émission hors bande 34, 34' avec un niveau désiré d'émission hors bande 36, 36', délivrant l'information de contrôle de linéarité 7 ; et
- les moyens 6 de commande de la polarisation de l'amplificateur 1, recevant l'information de contrôle de linéarité 7 et générant le signal de polarisation 4.

Le réglage de la polarisation se fait donc de la façon suivante : les moyens 33, 33' d'analyse estiment le niveau réel d'émission hors bande 34, 34', puis les moyens 35 de comparaison comparent ce niveau réel d'émission hors bande 34, 34' à un niveau désiré hors bande 36, 36', et enfin les moyens 6 de commande reçoivent le résultat 7 de cette comparaison et l'utilisent pour calculer le signal de polarisation 4, ce signal de polarisation 4 étant tel que :
- si le niveau réel d'émission hors bande est supérieur au niveau désiré d'émission hors bande, la polarisation va être modifiée de façon à réduire le niveau réel d'émission hors bande : on améliore la linéarité mais on réduit le rendement;
- si le niveau réel d'émission hors bande est inférieur au niveau désiré d'émission hors bande, la polarisation va être modifiée de façon à augmenter le niveau réel d'émission hors bande : on améliore le rendement mais on réduit la linéarité.

Le dispositif peut éventuellement comprendre des moyens 37 de conversion (en bande de base ou en fréquence intermédiaire) du signal prélevé 32. Dans ce cas, les moyens 33, 33' d'analyse reçoivent un signal converti 38.

De même, les moyens 6 de commande peuvent éventuellement prendre en compte, en plus de l'information de contrôle de linéarité, des paramètres extérieurs et notamment :
- la tension d'alimentation 39 de l'amplificateur (délivrée par des moyens 310 de mesure appropriés) ;
- la température 311 de l'amplificateur (délivrée par des moyens 312 de mesure appropriés) ; et
- une valeur de puissance de sortie requise 313 (délivrée par des moyens non représentés).

Dans le cas du second mode de réalisation (cf figure 3), l'amplificateur 1 reçoit uniquement un signal utile à amplifier 2 et le dispositif de l'invention est mis en oeuvre lorsque l'amplificateur reçoit ce signal utile à amplifier 2.

Comme présenté sur la figure 5, les moyens 33, d'analyse sont par exemple constitués des moyens suivants :
- des moyens 51 d'échantillonnage du signal prélevé 32 (ou converti 38), délivrant un signal échantillonné 52 ;
- des moyens 53 de conversion analogique/numérique recevant le signal échantillonné 52 et délivrant un signal numérique 54 ; et
- des moyens 55 de traitement numérique recevant le signal numérique 54 et délivrant le niveau réel d'émission hors bande 34.

Ainsi, les moyens 33 d'analyse estiment directement le niveau réel d'émission hors bande 34 à partir du signal prélevé 32 (ou converti 38). Plus précisément, les moyens 55 de traitement numérique (compris dans les moyens 33 d'analyse) mettent en oeuvre une analyse spectrale du signal numérique 54, par exemple par Transformée de Fourier Discrète, puis génèrent le niveau réel d'émission hors bande en s'appuyant sur le résultat de l'analyse spectrale. En effet, l'analyse spectrale permet de déterminer un spectre de puissance du signal numérique 54, qui associe une puissance à chacune des fréquences de ce spectre. La génération du niveau réel d'émission hors bande 34 consiste alors à cumuler les puissances associées à une bande de fréquences prédéterminée située hors de la bande de fréquences allouée à l'amplificateur 1. Le niveau désiré d'émission hors bande 36 est alors un niveau maximal prédéterminé de puissance cumulée.

Dans le cas du troisième mode de réalisation (cf figure 4), l'amplificateur 1 reçoit un signal d'entrée à amplifier 2 constitué soit d'un signal utile à amplifier, soit d'un signal de test, et est mis en oeuvre uniquement lorsqu'il reçoit le signal de test.

Comme présenté sur la figure 4, dans ce troisième mode de réalisation, le dispositif comprend un élément supplémentaire par rapport au deuxième mode de réalisation présenté sur la figure 3, à savoir des moyens 44 de génération :
- soit d'un signal de test, lorsque la polarisation de l'amplificateur doit être ajustée ;
- soit d'un signal utile à amplifier, lorsque ces moyens 44 reçoivent un flux d'informations utiles à amplifier.

Le signal de test est par exemple constitué de plusieurs signaux sinusoïdaux (on parle également de signal multi-ton), et les moyens 33' d'analyse estiment indirectement le niveau réel d'émission hors bande 34' à partir du signal prélevé 32 (ou converti 38) correspondant au signal de test après amplification.

En effet, il est connu que lorsque plusieurs sinusoïdes sont amplifiées simultanément par un élément non linéaire, on obtient en sortie, en plus des sinusoïdes présentes à l'entrée ayant été amplifiées, des signaux parasites appelés produits d'intermodulation (cf le chapitre I. 10 de l'ouvrage ``Télécommunications spatiales : I. bases théoriques'', publié aux éditions MASSON en 1982 par le CNES et le CNET).

Le niveau réel d'émission hors bande 34' est donc défini ici comme le niveau des produits d'intermodulation, par exemple d'ordre impair égal à trois (ou tout autre ordre impair supérieur à 3).

Ainsi, on peut prendre comme signal de test deux sinusoïdes de même amplitude et de fréquences proches f₁, f₂ (avec f₁< f₂) situées dans la bande d'utilisation de l'amplificateur. Les produits d'intermodulation d'ordre trois tombant dans la bande utile possèdent les fréquences (2 f₁- f₂) et (2 f₂- f₁).

L'analyse effectuée par les moyens 33' consiste à déterminer un jeu de coefficients réels (réels est ici à prendre dans le sens opposé à désiré), où chaque coefficient réel correspond à la puissance d'un des produits d'intermodulation. Ce jeu de coefficients réel correspond au niveau réel d'émission hors bande 34' et le niveau désiré d'émission hors bande 36' est alors un jeu de coefficients maximaux prédéterminés correspondant à une majoration de chacun des coefficients réels. Les coefficients maximaux prédéterminés peuvent être déterminés lors de la conception (par simulation ou mesure).

Cette analyse peut se concevoir en analogique. Dans ce cas, les moyens 33' d'analyse sont constitués de filtres analogiques étroits centrés sur les fréquences des produits d'intermodulation que l'on cherche à mesurer. Il y a alors autant de coefficients réels que de sortie de filtres analogiques.

Selon une variante, l'analyse peut se concevoir en numérique. Dans ce cas, les moyens 33' d'analyse sont du type présenté sur la figure 5 et comprennent des moyens 51 d'échantillonnage, des moyens 53 de conversion analogique/numérique et des moyens 55' de traitement numérique.

Les moyens 55' de traitement numérique se distinguent de ceux 55 décrits précédemment en ce qu'après avoir déterminé un spectre de puissance du signal numérique, ils génèrent le niveau réel d'émission hors bande sous la forme d'un jeu de coefficients réels correspondant chacun à la puissance d'un des produits d'intermodulation que l'on cherche à mesurer.

De nombreux algorithmes peuvent être utilisés pour estimer le niveau des produits d'intermodulation. Dans la mesure où l'on connaît le nombre et les fréquences des produits d'intermodulation, on peut utiliser de façon performante une méthode d'identification basée sur un modèle ARMA adapté au nombre de produits d'intermodulation présents (c'est-à-dire au nombre de sinusoïdes présentes) (cf chapitre 6 de la seconde édition du livre ``Optimum Signal Processing : An introduction'' (Traitement Optimal du Signal : Une introduction) de S. F. Orfanidis, publié en 1990 par Mc Graw - Hill Book Company).

Il est à noter que lorsque l'amplificateur est associé à un dispositif de linéarisation comportant une boucle de contre-réaction, certains éléments de cette boucle de contre-réaction peuvent être utilisés par le dispositif de l'invention. Ces éléments communs au dispositif de linéarisation et au dispositif de l'invention sont par exemple :
- les moyens 31 de prélèvement du signal de sortie amplifié 3 ;
- les moyens 37 de conversion (en bande de base ou en fréquence intermédiaire) du signal prélevé 32 ;
- les moyens 51 d'échantillonnage du signal prélevé 32 (ou converti 38) ; et
- les moyens 53 de conversion analogique/numérique du signal échantillonné 52.

## Revendications

1. Dispositif de commande de la polarisation d'un amplificateur (1) du type recevant un signal d'entrée à amplifier (2) et un signal de polarisation (4), et délivrant un signal de sortie amplifié (3), ledit amplificateur (1) possédant au moins deux valeurs distinctes de puissance de sortie possibles et émettant ledit signal de sortie amplifié (3) principalement dans une bande de fréquences prédéterminée,
caractérisé en ce qu'il comprend des moyens (6) de commande de la polarisation dudit amplificateur (1) qui reçoivent une information de contrôle de linéarité (7), et génèrent ledit signal de polarisation (4) en fonction de ladite information de contrôle de linéarité et de façon qu'un niveau réel d'émission hors bande soit sensiblement égal à un niveau désiré d'émission hors-bande,
ledit niveau réel d'émission hors bande étant défini comme un niveau d'émission dudit signal de sortie amplifié (3) hors de ladite bande de fréquences prédéterminées, et ledit niveau désiré d'émission hors bande étant défini comme un niveau seuil maximal prédéterminé d'émission hors bande, pour n'importe laquelle desdites valeurs distinctes de puissance de sortie possibles.

2. Dispositif selon la revendication 1, caractérisé en ce que ladite information de contrôle de linéarité (7) est une valeur de puissance de sortie requise parmi lesdites au moins deux valeurs distinctes de puissance de sortie possibles, lesdits moyens (6) de commande associant un signal de polarisation distinct (4) à chacune desdites au moins deux valeurs distinctes de puissance de sortie possibles, chaque signal de polarisation distinct (4) étant prédéterminé de façon que, pour la valeur de puissance de sortie à laquelle il est associé, le niveau réel d'émission hors bande soit sensiblement égal au niveau désiré d'émission hors bande.

3. Dispositif selon la revendication 1, caractérisé en ce qu'il comprend :
- des moyens (31) de prélèvement dudit signal de sortie amplifié (3), fournissant un signal prélevé (32) ;
- des moyens (33 ; 33') d'analyse recevant ledit signal prélevé (32) et délivrant un niveau réel d'émission hors-bande (34 ; 34') déterminé à partir dudit signal prélevé (32) ;
- des moyens (35) de comparaison dudit niveau réel d'émission hors bande (34 ; 34') avec ledit niveau désiré d'émission hors-bande (36 ; 36'), lesdits moyens (35) de comparaison délivrant un résultat (7) qui est ladite information de contrôle de linéarité.

4. Dispositif selon la revendication 3, caractérisé en ce qu'il comprend des moyens (37) de conversion dudit signal prélevé (32), délivrant un signal converti (38) auxdits moyens (33 ; 33') d'analyse, et en ce que lesdits moyens (37) de conversion appartiennent au groupe comprenant les moyens de conversion en bande de base et les moyens de conversion en fréquence intermédiaire.

5. Dispositif selon l'une quelconque des revendications 3 et 4, ledit amplificateur (1) étant du type recevant uniquement un signal utile à amplifier (2), caractérisé en ce que ledit dispositif est mis en oeuvre lorsque ledit amplificateur reçoit ledit signal utile à amplifier.

6. Dispositif selon la revendication 5, caractérisé en ce que lesdits moyens (33) d'analyse comprennent :
- des moyens (51) d'échantillonnage dudit signal prélevé, délivrant un signal échantillonné (52) ;
- des moyens (53) de conversion analogique/numérique recevant ledit signal échantillonné et délivrant un signal numérique (54) ; et
- des moyens (55) de traitement numérique recevant ledit signal numérique et délivrant ledit niveau réel d'émission hors bande (34),
en ce que lesdits moyens (55) de traitement numérique :
- mettent en oeuvre une analyse spectrale de façon à déterminer un spectre de puissance dudit signal numérique (54), associant une puissance à chacune des fréquences dudit spectre, et
- génèrent ledit niveau réel d'émission hors bande (34) sous la forme d'un cumul de puissances associées à une partie prédéterminée des fréquences situées hors de ladite bande de fréquences prédéterminée,
et en ce que ledit niveau désiré d'émission hors bande (36) est défini comme un niveau maximal prédéterminé de puissance cumulée.

7. Dispositif selon l'une quelconque des revendications 3 et 4, caractérisé en ce qu'il comprend des moyens (44) de génération d'au moins un des signaux appartenant au groupe comprenant un signal de test et un signal utile à amplifier,
et en ce qu'il est mis en oeuvre uniquement lorsque ledit amplificateur reçoit ledit signal de test.

8. Dispositif selon la revendication 7, caractérisé en ce que ledit signal de test est constitué d'au moins deux signaux sinusoïdaux à amplifier, ledit signal de sortie amplifié (3) étant constitué notamment d'au moins deux premiers signaux sinusoïdaux de même fréquence que lesdits au moins deux signaux sinusoïdaux à amplifier, et de seconds signaux sinusoïdaux de fréquences distinctes de celles desdits au moins deux signaux sinusoïdaux à amplifier, lesdits seconds signaux sinusoïdaux étant des produits d'intermodulation,
et en ce que ledit niveau réel d'émission hors bande (34') déterminé par lesdits moyens (33') d'analyse est un niveau desdits seconds signaux sinusoïdaux.

9. Dispositif selon la revendication 8, caractérisé en ce que ledit signal de test est constitué de deux signaux sinusoïdaux à amplifier d'amplitudes sensiblement égales et de fréquences proches et situées dans ladite bande de fréquences prédéterminée,
et en ce que lesdits seconds signaux sinusoïdaux sont des produits d'intermodulation d'ordre impair au moins égal à trois.

10. Dispositif selon l'une quelconque des revendications 8 et 9, caractérisé en ce que lesdits moyens (33') d'analyse sont constitués de filtres analogiques étroits centrés sur les fréquences desdits seconds signaux sinusoïdaux, et génèrent ledit niveau réel d'émission hors bande (34') sous la forme d'un jeu de coefficients réels, chacun desdits coefficients réels correspondant à une puissance de sortie d'un desdits filtres analogiques,
et en ce que ledit niveau désiré d'émission hors bande (36') est défini comme un jeu de coefficients maximaux prédéterminés.

11. Dispositif selon l'une quelconque des revendications 8 et 9, caractérisé en ce que lesdits moyens (33') d'analyse comprennent :
- des moyens (51) d'échantillonnage dudit signal prélevé, délivrant un signal échantillonné;
- des moyens (53) de conversion analogique/numérique recevant ledit signal échantillonné et délivrant un signal numérique ; et
- des moyens (55') de traitement numérique recevant ledit signal numérique et délivrant ledit niveau réel d'émission hors bande (34'),
en ce que lesdits moyens (55') de traitement numérique :
- mettent en oeuvre une analyse spectrale de façon à déterminer un spectre de puissance dudit signal numérique associant une puissance à chacune des fréquences dudit spectre, et
- génèrent ledit niveau réel d'émission hors bande (34') sous la forme d'un jeu de coefficients réels, chacun desdits coefficients réels correspondant à une puissance d'un desdits seconds signaux sinusoïdaux,
et en ce que ledit niveau désiré d'émission hors bande (36') est défini comme un jeu de coefficients maximaux prédéterminés.

12. Dispositif selon l'une quelconque des revendications 1 à 11, caractérisé en ce qu'il comprend des moyens (22, 23 ; 310, 312) de mesure d'au moins un paramètre extérieur, et en ce que lesdits moyens (6) de commande reçoivent également ledit au moins un paramètre extérieur et génèrent ledit signal de polarisation (4) en fonction également dudit au moins un paramètre extérieur.

13. Dispositif selon les revendications 2 et 12, caractérisé en ce que ledit au moins un paramètre extérieur appartient au groupe comprenant :
- une tension d'alimentation dudit amplificateur ; et
- une température dudit amplificateur.

14. Dispositif selon la revendication 12 et l'une quelconque des revendications 3 à 11, caractérisé en ce que ledit au moins un paramètre extérieur appartient au groupe comprenant :
- une tension d'alimentation dudit amplificateur ;
- une température dudit amplificateur ; et
- une valeur de puissance de sortie requise parmi lesdites au moins deux valeurs distinctes de puissance de sortie possibles.

15. Dispositif selon l'une quelconque des revendications 1 à 14, ledit amplificateur (1) étant du type associé à un dispositif de linéarisation comportant une boucle de contre-réaction, caractérisé en ce que ledit dispositif de commande de la polarisation utilise au moins partiellement ladite boucle de contre-réaction.

16. Dispositif selon la revendication 15 et l'une quelconque des revendications 6 et 11 à 14, caractérisé en ce que ladite boucle contre-réaction comprend au moins certains des moyens appartenant au groupe comprenant :
- lesdits moyens (31) de prélèvement du signal de sortie amplifié ;
- lesdits moyens (37) de conversion dudit signal prélevé ;
- lesdits moyens (51) d'échantillonnage du signal prélevé ; et
- lesdits moyens (53) de conversion analogique/numérique du signal échantillonné.

## Patentansprüche

1. Vorrichtung zur Steuerung der Polarisation eines Verstärkers (1) des Typs, der ein zu verstärkendes Eingangssignal (2) und ein Polarisationssignal (4) empfängt und ein verstärktes Ausgangssignal (3) liefert, wobei der Verstärker (1) wenigstens zwei mögliche verschiedene Werte der Ausgangsleistung besitzt und das verstärkte Ausgangssignal (3) hauptsächlich in einem vorbestimmten Frequenzband sendet,
dadurch gekennzeichnet, daß sie Mittel (6) zur Steuerung der Polarisation des Verstärkers (1) umfaßt, die eine Linearitätskontrollinformation (7) empfangen und das Polarisationssignal (4) in Abhängigkeit von der Linearitätskontrollinformation erzeugen, und so, daß ein tatsächlicher Außerbandsendepegel im wesentlichen gleich einem gewünschten Außerbandsendepegel ist,
wobei der tatsächliche Außerbandsendepegel als ein Außerbandsendepegel des verstärkten Ausgangssignals (3) außerhalb des Bandes von vorbestimmten Frequenzen definiert ist und der gewünschte Außerbandsendepegel als vorbestimmter maximaler Schwellenpegel der Außerbandsendung definiert ist, egal für welche der möglichen verschiedenen Werte der Ausgangsleistung.

2. Vorrichtung nach Anspruch 1, dadurch gekennzeichnet, daß die Linearitätskontrollinformation (7) ein Wert der erforderlichen Ausgangsleistung unter den wenigstens zwei möglichen verschiedenen Werten der Ausgangsleistung ist, wobei die Steuerungsmittel (6) mit jedem der wenigstens zwei möglichen verschiedenen Werte der Ausgansleistung ein unterschiedliches Polarisationssignal (4) verbinden, wobei jedes unterschiedliche Polarisationssignal (4) so vorbestimmt ist, daß für den Wert der Ausgangsleitung, mit dem es verbunden ist, der tatsächliche Außerbandsendepegel im wesentlichen gleich dem gewünschten Außerbandsendepegel ist.

3. Vorrichtung nach Anspruch 1, dadurch gekennzeichnet, daß sie umfaßt:
- Mittel (31) zur Abnahme des verstärkten Ausgangssignals (3), die ein abgenommenes Signal (32) bereitstellen,
- Analysemittel (33, 33'), die das abgenommene Signal (32) empfangen und einen tatsächlichen Außerbandsendepegel (34, 34') liefern, der ausgehend von dem abgenommenen Signal (32) bestimmt ist,
- Mittel (35) zum Vergleich des tatsächlichen Außerbandsendepegels (34, 34') mit dem gewünschten Pegel (36, 36') der Emission außerhalb des Bandes, wobei die Vergleichsmittel (35) ein Ergebnis (7) liefern, das die Linearitätskontrollinformation ist.

4. Vorrichtung nach Anspruch 3, dadurch gekennzeichnet, daß sie Mittel (37) zur Umwandlung des abgenommenen Signals (32) umfaßt, die ein umgewandeltes Signal (38) an die Analysemittel (33, 33') liefern, und daß die Umwandlungsmittel (37) zu der Gruppe gehören, die die Mittel zur Umwandlung im Basisband und die Mittel zur Umwandlung in der Zwischenfrequenz umfassen.

5. Vorrichtung nach einem der Ansprüche 3 und 4, wobei der Verstärker (1) von dem Typ ist, der einzig und allein ein zu verstärkendes Nutzsignal (2) empfängt, dadurch gekennzeichnet, daß die Vorrichtung benutzt wird, wenn der Verstärker das zu verstärkende Nutzsignal empfängt.

6. Vorrichtung nach Anspruch 5, dadurch gekennzeichnet, daß die Analysemittel (33) umfassen:
- Mittel (51) zum Abtasten des abgenommenen Signals, die ein abgetastetes Signal (52) liefern,
- Mittel (53) zur A/D-Umwandlung, die das abgetastete Signal empfangen und ein Digitalsignal (54) liefern, und
- Mittel (55) zur rechnerischen Behandlung, die das Digitalsignal empfangen und den tatsächlichen Außerbandsendepegel (34) liefern,
und daß die Mittel (55) zur rechnerischen Behandlung:
- eine Spektralanalyse ausführen, um ein Leistungsspektrum des Digitalsignals (54) zu bestimmen, das mit jeder der Frequenzen des Spektrums eine Leistung verbindet, und
- den tatsächlichen Außerbandsendepegel (34) der Emission außerhalb des Bandes in Form einer Summe von Leistungen erzeugen, die mit einem vorbestimmten Teil der Frequenzen verbunden sind, die sich außerhalb des vorbestimmten Frequenzbandes befinden,
und daß der gewünschte Außerbandsendepegel (36) als ein vorbestimmter maximaler Pegel der summierten Leistung definiert ist.

7. Vorrichtung nach einem der Ansprüche 3 und 4, dadurch gekennzeichnet, daß sie Mittel (44) zur Erzeugung wenigstens eines der Signale umfaßt, die zu der Gruppe gehören, die ein Prüfsignal und ein zu verstärkendes Nutzsignal umfaßt,
und daß sie einzig und allein benutzt wird, wenn der Verstärker das Prüfsignal empfängt.

8. Vorrichtung nach Anspruch 7, dadurch gekennzeichnet, daß das Prüfsignal aus wenigstens zwei zu verstärkenden Sinussignalen besteht, wobei das verstärkte Ausgangssignal (3) insbesondere aus wenigstens zwei ersten Sinussignalen mit der gleichen Frequenz wie die wenigstens zwei zu verstärkenden Sinussignale, und zweiten Sinussignalen mit Frequenzen besteht, die von denjenigen der wenigstens zwei zu verstärkenden Sinussignal verschieden sind, wobei die zweiten Sinussignale Intermodulations- und daß der tatsächliche Außerbandsendepegel (34'), der von den Analysemitteln (33') bestimmt wird, ein Pegel der zweiten Sinussignale ist.

9. Vorrichtung nach Anspruch 8, dadurch gekennzeichnet, daß das Prüfsignal aus zwei zu verstärkenden Sinussignalen mit im wesentlichen gleichen Amplituden und mit nahe beieinander liegenden Frequenzen besteht und die im vorbestimmten Frequenzband liegen,
und daß die zweiten Sinussignale Intermodulationsprodukte ungerader Ordnung von wenigstens gleich drei sind.

10. Vorrichtung nach einem der Ansprüche 8 und 9, dadurch gekennzeichnet, daß die Analysemittel (33') aus engen Analogfiltern bestehen, die auf die Frequenzen der zweiten Sinussignale zentriert sind, und den tatsächlichen Außerbandsendepegel (34') in Form eines Satzes von tatsächlichen Koeffizienten erzeugen, wobei jeder der tatsächlichen Koeffizienten einer Ausgangsleistung eines der Analogfilter entspricht,
und daß der gewünschte Außerbandsendepegel (36') als Satz vorbestimmter maximaler Koeffizienten definiert ist.

11. Vorrichtung nach einem der Ansprüche 8 und 9, dadurch gekennzeichnet, daß die Analysemittel (33') umfassen:
- Mittel (51) zum Abtasten des abgenommenen Signals, die ein abgetastetes Signal liefern,
- Mittel (53) zur A/D-Umwandlung, die das abgetastete Signal empfangen und ein Digitalsignal liefern, und
- Mittel (55') zur rechnerischen Behandlung, die das Digitalsignal empfangen und den tatsächlichen Außerbandsendepegel (34') liefern,
und daß die Mittel (55') zur rechnerischen Behandlung:
- eine Spektralanalyse ausführen, um ein Leistungsspektrum des digitalsignals zu bestimmen, das mit jeder der Frequenzen des Spektrums eine Leistung verbindet, und
- den tatsächlichen Außerbandsendepegel (34') in Form eines Satzes von tatsächlichen Koeffizienten erzeugen, wobei jeder der tatsächlichen Koeffizienten einer Leistung eines der zweiten Sinussignale entspricht,
und daß der gewünschte Außerbandsendepegel (36') als Satz vorbestimmter maximaler Koeffizienten definiert ist.

12. Vorrichtung nach einem der Ansprüche 1 bis 11, dadurch gekennzeichnet, daß sie Mittel (22, 23; 310, 312) zur Messung wenigstens eines äußeren Parameters umfaßt und daß die Steuerungsmittel (6) auch den wenigstens einen äußeren Parameter empfangen und das Polarisationssignal (4) auch in Abhängigkeit von dem wenigstens einen äußeren Parameter erzeugen.

13. Vorrichtung nach den Ansprüchen 2 und 12, dadurch gekennzeichnet, daß der wenigstens eine äußere Parameter zu der Gruppe gehört, die umfaßt:
- eine Versorgungsspannung des Verstärkers und
- eine Temperatur des Verstärkers.

14. Vorrichtung nach Anspruch 12 und einem der Ansprüche 3 bis 11, dadurch gekennzeichnet, daß der wenigstens eine äußere Parameter zu der Gruppe gehört, die umfaßt:
- eine Versorgungsspannung des Verstärkers,
- eine Temperatur des Verstärkers, und
- einen Wert der erforderlichen Ausgangsleistung unter den wenigstens zwei möglichen verschiedenen Werten der Ausgangsleistung.

15. Vorrichtung nach einem der Ansprüche 1 bis 14, wobei der Verstärker (1) von dem Typ ist, der mit einer Linearisierungseinrichtung verbunden ist, die eine Rückkopplungsschleife aufweist, dadurch gekennzeichnet, daß die Einrichtung zur Steuerung der Polarisation wenigstens teilweise die Rückkopplungsschleife nutzt.

16. Vorrichtung nach Anspruch 15 und einem der Ansprüche 6 und 11 bis 14, dadurch gekennzeichnet, daß die Rückkopplungsschleife wenigstens einige der Mittel umfaßt, die zu er Gruppe gehören, die umfaßt:
- die Mittel (31) zur Abnahme des verstärkten Ausgangssignals,
- die Mittel (37) zur Umwandlung des abgenommenen Signals,
- die Mittel (51) zur Abtastung des abgenommenen Signals und
- die Mittel (53) zur A/D-Umwandlung des abgetasteten Signals.

## Claims

1. Device for controlling the biasing of an amplifier (1) of the type receiving an input signal (2) to be amplified and a bias signal (4) and supplying an amplified output signal (3), said amplifier (1) having at least two separate possible power output values and sending said amplified output signal (3) principally in a predetermined frequency band,
characterised in that it comprises means (6) for controlling the biasing of said amplifier (1) which receive linearity control information (7) and generate said bias signal (4) in accordance with said linearity control information and so that an actual out-band send level is substantially equal to the required out-band send level,
said actual out-band send level being defined as a send level of said amplified output signal (3) outside said predetermined frequency band and said required out-band send level being defined as a predetermined maximal out-band send threshold level for any of said separate possible output power values.

2. Device according to claim 1 characterised in that said linearity control information (7) is a required output power value selected from said at least two separate possible output power values, said control means (6) associating a separate bias signal (4) with each of said at least two separate possible power output values, each separate bias signal (4) being predetermined so that, for the associated output power value, the actual out-band send level is substantially equal to the required out-band send level.

3. Device according to claim 1 characterised in that it comprises:
- copying means (31) for copying said amplified output signal (3) and supplying a copied signal (32);
- analyser means (33; 33') receiving said copied signal (32) and supplying an actual out-band send level (34; 34') determined from said copied signal (32);
- comparator means (35) for comparing said actual out-band send level (34; 34') with said required out-band send level (36; 36') and supplying a result (7) constituting said linearity control information.

4. Device according to claim 3 characterised in that it comprises converter means (37) for converting said copied signal (32) and supplying a converted signal (38) to said analyser means (33; 33'), and in that said converter means (37) are selected from the group comprising baseband converter means and intermediate frequency converter means.

5. Device according to claim 3 or claim 4, said amplifier (1) being of the type receiving only a wanted signal (2) to be amplified, characterised in that said device is activated when said amplifier receives said wanted signal to be amplified.

6. Device according to claim 5 characterised in that said analyser means (33) comprise:
- sampling means (51) for sampling said copied signal and supplying a sampled signal (52);
- analogue/digital converter means (53) receiving said sampled signal and supplying a digital signal (54); and
- digital signal processor means (55) receiving said digital signal and supplying said actual out-band send level (34),
and in that said digital signal processor means (55):
- carry out spectrum analysis to determine a power spectrum of said digital signal (54), associating a power with each frequency of said spectrum, and
- generate said actual out-band send level (34) in the form of a cumulative total of powers associated with predetermined frequencies outside said predetermined frequency band,
and in that said required out-band send level (36) is defined as a predetermined maximal cumulative power level.

7. Device according to claim 3 or claim 4 characterised in that it comprises means (44) for generating at least one signal selected from the group comprising a test signal and a wanted signal to be amplified,
and in that it is activated only when said amplifier receives said test signal.

8. Device according to claim 7 characterised in that said test signal comprises at least two sinusoidal signals to be amplified, said amplified output signal (3) comprising at least two first sinusoidal signals with the same frequencies as said at least two sinusoidal signals to be amplified and second sinusoidal signals with frequencies different from those of said at least two sinusoidal signals to be amplified, said second sinusoidal signals being intermodulation products,
and in that said actual out-band send level (34') determined by said analyser means (33') is a level of said second sinusoidal signals.

9. Device according to claim 8 characterised in that said test signal comprises two sinusoidal signals to be amplified of substantially the same amplitude and at similar frequencies in said predetermined frequency band,
and in that said second sinusoidal signals are intermodulation products of an odd order at least equal to three.

10. Device according to claim 8 or claim 9 characterised in that said analyser means (33') comprise narrowband analogue filters centred on the frequencies of said second sinusoidal signals and generate said actual out-band send level (34') in the form of a set of actual coefficients, each of said actual coefficients corresponding to an output power of one of said analogue filters,
and in that said required out-band send level (36') is defined as a set of predetermined maximal coefficients.

11. Device according to claim 8 or claim 9 characterised in that said analyser means (33') comprise:
- sampling means (51) for sampling said copied signal and supplying a sampled signal;
- analogue/digital converter means (53) receiving said sampled signal and supplying a digital signal; and
- digital signal processor means (55') receiving said digital signal and supplying said actual out-band send level (34'),
and in that said digital signal processor means (55'):
- carry out spectrum analysis to determine a power spectrum of said digital signal, associating a power with each frequency of said spectrum, and
- generate said actual out-band send level (34') in the form of a set of actual coefficients each corresponding to a power of one of said second sinusoidal signals,
and in that said required out-band send level (36') is defined as a set of predetermined maximal coefficients.

12. Device according to any one of claims 1 to 11 characterised in that it comprises means (22, 23; 310, 312) for measuring at least one external parameter and in that said control means (6) also receive said at least one external parameter and generate bias signal (4) also in accordance with said at least one external parameter.

13. Device according to claim 2 and claim 12 characterised in that said at least one external parameter is selected from the group comprising:
- a supply voltage of said amplifier; and
- a temperature of said amplifier.

14. Device according to claim 12 and any one of claims 3 to 11 characterised in that said at least one external parameter is selected from the group comprising:
- a supply voltage of said amplifier;
- a temperature of said amplifier; and
- a required output power value selected from said at least two separate possible output power values.

15. Device according to any one of claims 1 to 14, said amplifier (1) being of the type associated with a lineariser device including a feedback loop, characterised in that said bias control device uses at least part of said feedback loop.

16. Device according to claim 15 and any one of claims 6 and 11 to 14 characterised in that said feedback loop comprises at least some means selected from the group comprising:
- said amplified output signal copying means (31);
- said copied signal converter means (37);
- said copied signal sampling means (51); and
- said sampled signal analogue/digital converter means (53).
